(19) Europäisches Patentamt
European Patent Office
Office européen des brevets

(11) **EP 3 124 992 B1**

(12) **EUROPÄISCHE PATENTSCHRIFT**

(45) Veröffentlichungstag und Bekanntmachung des Hinweises auf die Patenterteilung:
**12.07.2017 Patentblatt 2017/28**

(51) Int Cl.:
**G01S 7/486** (2006.01)      **H01L 31/02** (2006.01)
**G01J 1/44** (2006.01)

(21) Anmeldenummer: **15178508.6**

(22) Anmeldetag: **27.07.2015**

(54) **LICHTEMPFÄNGER MIT LAWINENPHOTODIODEN IM GEIGER-MODUS UND VERFAHREN ZUM AUSLESEN**

LIGHT RECEIVING DEVICE WITH AVALANCHE PHOTODIODES IN GEIGER MODE AND METHOD FOR READING

RÉCEPTEUR DE LUMIÈRE AYANT DES PHOTODIODES À AVALANCHE EN MODE GEIGER ET PROCÉDÉ DE LECTURE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**01.02.2017 Patentblatt 2017/05**

(73) Patentinhaber: **SICK AG**
**79183 Waldkirch (DE)**

(72) Erfinder:
• **Clemens, Klaus**
**79367 Weisweil (DE)**
• **Hug, Gottfried**
**79183 Waldkirch (DE)**
• **Seitz, Stefan**
**79341 Kenzingen (DE)**
• **Tschuch, Dr. Sebastian**
**79104 Freiburg (DE)**

(56) Entgegenhaltungen:
**GB-A- 2 451 678**

**Beschreibung**

Die Erfindung betrifft einen Lichtempfänger mit einer Vielzahl von Lawinenphotodiodenelementen, die in einem Geiger-Modus betrieben sind, sowie ein Verfahren zum Auslesen nach dem Oberbegriff von Anspruch 1 beziehungsweise 12.

Ein Lichtempfänger hat die Funktion, aus einfallendem Empfangslicht ein elektrisches Signal zu erzeugen. Die Nachweisempfindlichkeit einfacher Photodioden genügt in vielen Anwendungsfällen nicht. In einer Lawinenphotodiode (APD, Avalanche Photo Diode) löst das einfallende Licht einen kontrollierten Lawinendurchbruch (Avalanche Effect) aus. So werden die von einfallenden Photonen erzeugten Ladungsträger vervielfacht, und es entsteht ein Photostrom, der zu der Lichtempfangsintensität proportional, dabei aber wesentlich größer ist als bei einer einfachen PIN-Diode. Im sogenannten Geiger-Modus ist die Lawinenphotodiode oberhalb der Durchbruchspannung vorgespannt, so dass bereits ein einziger, durch ein einzelnes Photon freigesetzter Ladungsträger eine Lawine auslösen kann, die dann aufgrund der hohen Feldstärke sämtliche verfügbaren Ladungsträger rekrutiert. Die Lawinenphotodiode zählt somit wie der namensgebende Geigerzähler Einzelereignisse. Lawinenphotodioden im Geiger-Modus werden auch als SPAD (Single-Photon Avalanche Diode) bezeichnet. Eine weitere gängige Bezeichnung ist SiPM (Silicon Photo Multiplier), wobei Silizium nur der gängige, nicht aber einzige zugrunde liegende Halbleiter ist und SiPM ein ganzes Array von SPADs bezeichnet.

Die hohe Strahlungsempfindlichkeit von SPADs wird in vielen Anwendungen genutzt. Dazu zählen die Medizintechnik mit CT, MRT oder Blutanalysen, die optische Messtechnik einschließlich Spektroskopie, Entfernungsmessung und dreidimensionaler Bildgebung, die Strahlendetektion in der Kernphysik oder die Verwendungen in Teleskopen für die Astrophysik.

Geiger-APDS oder SPADs sind also sehr schnelle, hochempfindliche Photodioden auf Halbleiterbasis. Ein Nachteil der hohen Empfindlichkeit ist, dass nicht nur ein Nutzlichtphoton, sondern auch ein schwaches Störereignis durch Fremdlicht, optisches Übersprechen oder Dunkelrauschen den Lawinendurchbruch auslösen kann. Dieses Störereignis trägt dann mit dem gleichen relativ starken Signal zum Messergebnis bei wie das empfangene Nutzlicht und ist davon auch aus dem Signal heraus nicht unterscheidbar. Anschließend bleibt die Lawinenphotodiode für eine Totzeit von ca. 5 bis 100 ns unempfindlich und fällt solange für weitere Messungen aus. Deshalb ist es üblich, mehrere SPADs zusammenzuschalten und statistisch auszuwerten.

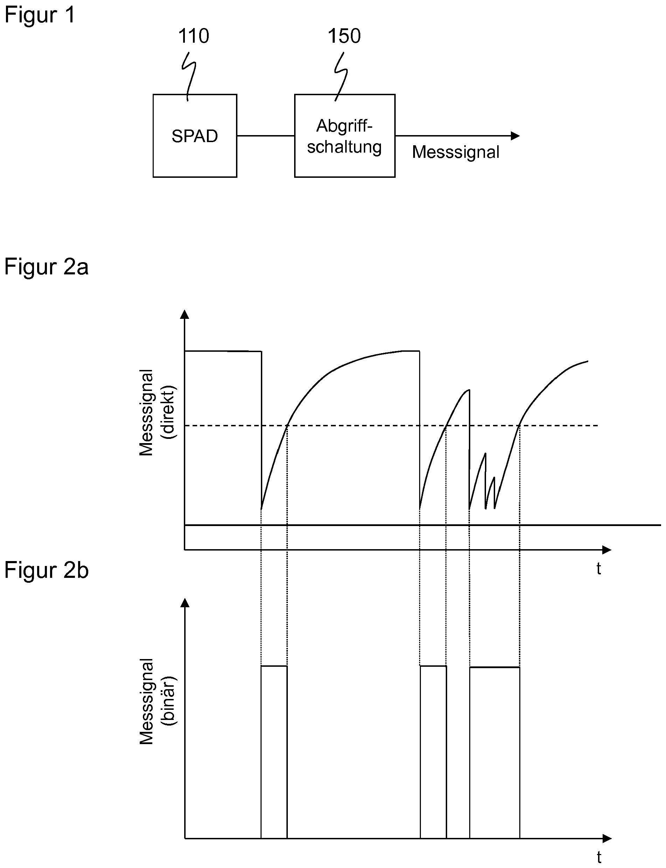

Um das elektrische Signal tatsächlich nutzen zu können, muss es auch aus dem SPAD-Detektorelement herauslesen oder abgegriffen werden. Dies zeigt Figur 1 in einem sehr groben Blockschaltbild. An das eigentliche Detektorelement 110 mit einer oder meist einer Vielzahl von SPADs ist eine Signalabgriffschaltung 150 angeschlossen, die das Messsignal in einer für nachfolgende Schaltungen verarbeitbaren Weise ausgibt.

Bei einer Betrachtung bekannter Lösungen sind zunächst einmal gepufferte und direkte Signalabgriffe zu unterscheiden. Figur 2a zeigt das ideale Messsignal bei einem direkten Signalabgriff, der also ein Nachvollziehen des zeitlichen Verlaufs der Lawinendurchbrüche und anschließenden Ladevorgänge ermöglicht. Die scharfen fallenden Kanten sind jeweils Detektionsereignisse durch einfallende Photonen, aufgrund derer die Vorspannung über der SPAD plötzlich einbricht und sich dann langsam mit der genannten Zeitkonstante im Bereich von 5ns erholt. Erkennbar ist der Lawinendurchbruch ein sehr schnelles Ereignis, so dass eine Auswertung des Geigerstroms im Prinzip extrem schnelle Antwortzeiten im Bereich deutlich unter 1 ns ermöglicht. Mit den bekannten Signalabgriffschaltungen gelingt es aber in der Praxis nicht, dieses ideale Messsignal tatsächlich nutzbar zu machen.

Bei einem gepufferten Signalabgriff mit digitalem Charakter wird das SPAD-Signal selbst gar nicht nach außen geführt, sondern in einer integrierten Pufferstufe mit einer Schwelle bewertet. Dies ist beispielhaft in Figur 2b illustriert. Dadurch wird zwar ein gut nutzbares Signal für die Weiterverarbeitung zur Verfügung gestellt. Es ergibt sich aber ein durch die Schwellenbewertung bedingter Informationsverlust. Insbesondere gehen Ereignisse, die zu früh während der Ladezeit noch im unterschwelligen Bereich auftreten, gänzlich verloren. Dies illustriert auch, warum ein gepufferter Signalabgriff für hochfrequente Signale weniger geeignet ist.

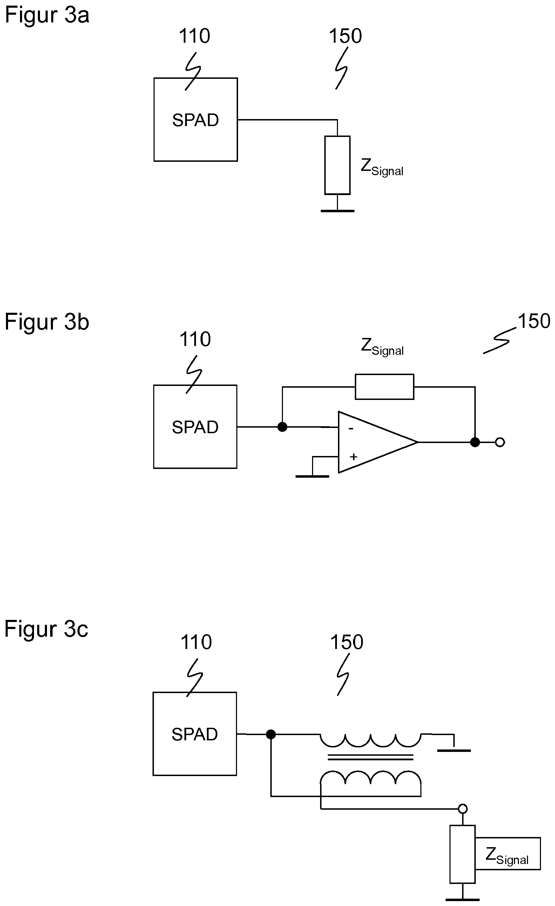

In einem direkten Signalabgriff soll das Messsignal den Verlauf des eigentlichen Signals in der SPAD, im Idealfall also den Verlauf nach Figur 2a wiedergeben. Die Figuren 3a-c zeigen einige für diesen Zweck übliche Beschaltungen. Gerade für hochfrequente Signale ist aber die Leistungsfähigkeit in allen Fällen unbefriedigend.

In einer einfachen Widerstandsauskopplung gemäß Figur 3a wird der Signal- oder Geigerstrom direkt über einen angeschlossenen Arbeitswiderstand (Impedanz $Z_{Signal}$) in eine entsprechende Messsignalspannung umgewandelt. Die Leistungsfähigkeit ist vor allem für hochfrequente Signale sehr begrenzt und wird erheblich von parasitären Kapazitäten beeinflusst, denn die Kombination aus Arbeitswiderstand und parasitären Kapazitäten stellt einen Tiefpass dar.

Herkömmlich vielfach genutzt ist eine Verstärkerschaltung mit einem Transimpedanzverstärker gemäß Figur 3b. Die Darstellung ist insofern vereinfacht, als solche Verstärker in der Praxis mehrstufig aufgebaut sind. Ein Rückkoppelwiderstand ($Z_{Signal}$) zwischen dem Ausgang der letzten Verstärkerstufe und dem Eingang der ersten Verstärkerstufe führt das Ausgangssignal in abgeschwächter Form dem Verstärkereingang wieder zu und bildet bei einer negativen Verstärkung eine Gegenkopplung. Schon im mittleren Frequenzbereich, also einigen MHz, führt die Gegenkopplung über mehrere Stufen zu erheblichen Phasenverschiebungen, da sich die einzelnen Laufzeiten der Verstärkerstufen aufaddieren. Somit stellt sich der am Verstärkereingang eigentlich gewünschte virtuelle Massepunkt für höhere Frequenzen nicht mehr ein. Der Eingangswiderstand des Verstärkerbildes errechnet sich näherungsweise zu

$$Z_{In} = Z_{Signal} / (1+\text{Verstärkung}).$$

Mit zunehmender Frequenz fällt die Verstärkung ab, und der Eingangswiderstand steigt an. Das Ansteigen des Widerstandes mit der Frequenz entspricht einem induktiven Verhalten. Im Zusammenhang mit parasitären Eingangskapazitäten bildet sich ein Schwingkreis aus, es kann also zu Instabilitäten und Schwingneigung kommen.

Ein weiteres Problem eines Signalabgriffs mit einem Transimpedanzverstärker stellt die Anpassung des von dem SPAD-Detektor kommenden Eingangssignals an den aktiven Teil des Verstärkers dar. Prinzipiell sind die Signalspannungen am virtuellen Massepunkt, der zugleich Verstärkereingang ist, minimal. Gleichzeitig sind für das Verstärkerelement selbst, beispielsweise einen Operationsverstärker, sehr hochohmige Eingangsimpedanzen üblich. Daraus ergibt sich, dass nur eine sehr kleine Signalleistung am aktiven Bereich des Verstärkerelements ankommt, nämlich das Produkt aus der minimalen Signalspannung am virtuellen Massepunkt und des wegen der Eingangsimpedanz sehr kleinen Eingangsstroms. Der wesentliche Anteil des vom SPAD-Detektor kommenden Signalstroms fließt über den Rückkoppelwiderstand und steht somit dem verstärkenden Element gar nicht zur Verstärkung zur Verfügung. Aus dieser ungünstigen Ankopplung ergibt sich ein schlechtes Signal/Rausch-Verhältnis.

Eine dritte, in Figur 3c dargestellte herkömmliche Lösung beruht auf einer Impedanzanpassung unter Verwendung von Transformatoren, in diesem Fall Hochfrequenztransformatoren oder sogenannten "Balun-Transformern". Solche Transformationen sind zunächst nur bis knapp 1 GHz geeignet. Auch dieser Frequenzbereich steht praktisch nicht zur Verfügung, da dies nur ein Idealwert ist, der bei von 50 Ohm abweichenden Schaltungsimpedanzen wegen Streuinduktivitäten und parasitären Kapazitäten nicht erreicht wird. Es gibt zwar auch Varianten von Leitungstransformatoren (Transmission Line Transformer) für höhere Frequenzen bis ca. 3 GHz und Sonderformen wie den Guanella-Transformator. Sie haben jedoch andere ungünstige Randbedingungen, aufgrund derer sie für einen optimalen Signalabgriff nicht in Frage kommen, weil sie sich beispielsweise zur Beschaltung zum Spartransformator nicht eignen oder nur Anwendungen in bestimmten Impedanzbereichen zulassen, die für einen SPAD-Detektor nicht passen.

Die WO 2011/117309 A2 schlägt vor, neben der Anode und Kathode für das Anlegen der Vorspannung eine dritte Elektrode an dem SPAD-Detektor vorzusehen, über welche der Geigerstrom kapazitiv ausgekoppelt wird. Dadurch soll verhindert werden, dass das Auslesen durch Schaltelemente der Vorspannung (Bias) verzögert wird. Mit dem eigentlichen Signalabgriff befasst sich das Dokument aber nicht.

Aus der GB 2 451 678 A ist eine SPM-Schaltung (Silicon Photomultiplier) bekannt, die mindestens ein Pixel mit mehreren Mikrozellen aufweist, die jeweils als Photodiode im Geiger-Modus ausgebildet sind. Es werden verschiedene Beschaltungen vorgeschlagen, um die Schalt- und Erholzeit der Mikrozellen zu minimieren, indem am Verbindungsknoten ein im Wesentlichen konstantes Potential aufrechterhalten wird. In einer Ausführungsform ist dafür ein Transistor vorgesehen.

Es ist daher Aufgabe der Erfindung, einen gattungsgemäßen Lichtempfänger anzugeben, der ein besseres Messsignal bereitstellt.

Diese Aufgabe wird durch einen Lichtempfänger mit einer Vielzahl von Lawinenphotodiodenelementen, die in einem Geiger-Modus betrieben sind, nach Anspruch 1, sowie ein Verfahren zum Auslesen nach Anspruch 12 gelöst. Die Lawinenphotodiodenelemente im Geiger-Modus oder SPADs wirken praktisch wie hoch lichtempfindliche Schalter, die durch Lichteinfall einen Geigerstrom auslösen. Die Erfindung beruht zunächst einmal auf der Erkenntnis, dass die bisherigen Lösungen zum Signalabgriff der Lawinenphotodiodenelemente aufgrund unzureichend optimierter Schaltungen nicht in der Lage sind, die sehr schnellen Abläufe bei einem Lawinendurchbruch im Messsignal widerzuspiegeln. Deshalb sieht die Erfindung ein aktives Kopplungselement vor, d. h. nicht nur passive Elemente wie einen Widerstand oder Transformator. Das Kopplungselement bietet für den Geigerstrom an seinem Eingang einen virtuellen Kurzschluss gegen ein vorzugsweise festes Potential. Praktisch wird dies nur bis auf wenige Ohm oder Bruchteile von einem Ohm gelingen. Es bedeutet aber, dass der Geigerstrom nahezu vollständig aus dem Detektor, also dem jeweils auslösenden Lawinenphotodiodenelement, in die Signalabgriffschaltung fließt und über den Kurzschluss abfließen kann, ganz anders als beispielsweise im einleitend beschriebenen Falle eines Messwiderstands. Deshalb kann die durch Vielzahl der SPAD Zellen gebildete parasitäre Kapazität am Ausgang des SiPM (Vielzahl zusammengeschalteter SPADs) nicht mehr wie ein Tiefpass wirken. Es finden quasi keine Umladevorgänge in den parasitären Kapazitäten mehr statt. Die schnellen hochfrequenten Geigerströme können im Wesentlichen ungehindert zum verstärkenden Element abfließen.

Weiter erzeugt das Kopplungselement an seinem Ausgang aktiv einen Messstrom, der dem Geigerstrom entspricht und damit insbesondere den gleichen zeitlichen Verlauf zeigt. Das Kopplungselement kann außerdem durch eine Verstärkung dafür sorgen, dass der Messstrom einen für die weitere Verarbeitung geeigneten Pegel aufweist. Zugleich wird der Messstrom durch das Kopplungselement nahezu vollständig von dem Geigerstrom entkoppelt. Die weitere Verarbeitung des Messstroms wirkt daher nicht auf den Geigerstrom zurück.

Die Erfindung hat den Vorteil, dass die Leistungsfähigkeit des Lichtempfängers vor allem in Bezug auf dessen Geschwindigkeit erheblich verbessert wird. Durch den direkten Signalabgriff bleibt der Verlauf des Geigerstroms für die weitere Verarbeitung zugänglich. Dies funktioniert auch noch für hohe Frequenzen und damit beispielsweise sehr kurze Pulse. Da der mit dem Detektionsereignis verfügbare Strom praktisch vollständig in das aktive Kopplungselement fließen kann, ergibt sich eine optimale Verstärkung mit sehr gutem Signal/Rausch-Verhältnis.

SPADs haben eine sehr hohe Empfindlichkeit, aber dieser Vorteil musste bisher mit dem Verzicht auf ein gutes Hochfrequenzverhalten erkauft werden. Die Erfindung ermöglicht nun eine Kombination von hoher Empfindlichkeit und Bandbreite. Dabei ist die Signalabgriffschaltung bauklein und sogar integrierbar und zeigt ein gutes Preis-Leistungsverhältnis. Insgesamt werden dadurch nicht nur bisher bekannte Anwendungen verbessert, sondern auch neue Anwendungsfelder für die SPAD-Technologie erschlossen.

Der Verlauf des Messstroms weicht bevorzugt erst für Änderungen im höheren Gigahertzbereich, insbesondere oberhalb zwei oder drei GHz, durch frequenzbedingte Verluste von dem Geigerstrom ab. Erst für Frequenzen des einfallenden Lichtsignals oberhalb von einigen GHz zeigt die Abbildung des Geigerstroms auf den Messstrom deutlich spürbare frequenzbedingte Verluste. Dies wird durch das aktive Kopplungselement ermöglicht. Im Gegensatz dazu fällt bei allen einleitend genannten herkömmlichen Lösungen das Messsignal schon bei mittleren Frequenzen von einigen hundert MHz, spätestens aber ab einem GHz um mehrere Dekaden ab. Somit gelingt es aufgrund der Erfindung, Pulse und Flanken mit einem SPAD-Detektor auch im Sub-Nanosekundenbereich aufzulösen.

Vorzugsweise ist eine Messschaltung an den Ausgang angeschlossen. Die Messschaltung dient also dazu, den Messstrom weiterzuverarbeiten. Bei dieser Messschaltung kann es sich durchaus wieder um einen einfachen Messwiderstand handeln, denn durch die Entkopplung in dem Kopplungselement wirkt sich dieser Messwiderstand gerade nicht mehr auf den Geigerstrom aus. Diese Entkopplung wirkt natürlich ebenso für andere denkbare Messschaltungen, wie weitere Verstärkerstufen oder Auswerteeinheiten.

Die Signalabgriffschaltung weist bevorzugt eine an das Kopplungselement angeschlossene Konstantstromquelle zur Einstellung von deren Arbeitspunkt auf. Es fließt also in einem Grundzustand ein Ruhestrom, und diesem Gleichstrom überlagert sich bei einem Detektionsereignis der Geigerstrom. Die Konstantstromquelle kann alternativ als passiver Widerstand ausgeführt werden.

Das Kopplungselement ist vorzugsweise dafür ausgebildet, die eingangsseitige Spannung konstant zu halten. Wenn nun ein Geigerstrom fließt, muss zum Aufrechthalten der Spannung vom Ausgang her ein Ausgangsstrom durch das Kopplungselement fließen. Auf diese Weise wird der Geigerstrom am Eingang auf einen entsprechenden Messstrom am Ausgang abgebildet.

Das Kopplungselement weist bevorzugt einen Transistor auf. Insbesondere ist dies genau ein Transistor, und nochmals bevorzugt besteht das Kopplungselement aus dem Transistor. Damit ist das Kopplungselement einstufig, nicht mehrstufig wie beispielsweise ein herkömmlich zum Auslesen eingesetzter Transimpedanzverstärker. Die technische Ausführung des Transistors ist nicht beschränkt und umfasst Bipolartransistoren oder Feldeffekttransistoren in ihren verschiedenen Bauformen. Allerdings sollte vorzugsweise ein Hochfrequenztransistor verwendet werden, um die erfindungsgemäßen Vorteile einer großen Bandbreite des Lichtempfängers tatsächlich zu erzielen.

Der Transistor ist vorzugsweise in Basisschaltung oder Gateschaltung betrieben, indem der Eingang mit dem Emitter oder mit Source, der Ausgang mit dem Kollektor oder mit Drain und die Basis oder das Gate mit einem festen Potential verbunden ist. Die jeweils alternativ genannten Begriffe beziehen sich einerseits auf einen Bipolartransistor und andererseits auf einen FET, um nochmals deutlich herauszustellen, dass der Transistor nicht auf eine bestimmte Technologie festgelegt sein soll. Obwohl prinzipiell auch die viel üblichere Emitterschaltung denkbar wäre, ist Basisschaltung durch einen niedrigen Eingangswiderstand, eine höhere Bandbreite und einen flacheren Frequenzgang überlegen.

Die Lawinenphotodiodenelemente weisen eine erste Elektrode und eine zweite Elektrode auf, über die sie vorgespannt sind. So wird die Bias- oder Vorspannung bereitgestellt, aus der sich der Lawinendurchbruch speist.

Zwischen einer Lawinenphotodiode des Lawinenphotodiodenelements und erster Elektrode oder zweiter Elektrode ist eine Ladeeinheit angeordnet. Die Ladeeinheit ist häufig ein Ladewiderstand, kann aber auch eine Stromquelle sein.

Die Lawinenphotodiodenelemente weisen eine dritte Elektrode zum kapazitiven Auskoppeln des Geigerstroms auf. Durch diese von der Bereitstellung der Vorspannung unabhängige dritte Elektrode ist ein schnelleres Auslesen möglich. Die dritte Elektrode ist zwischen der Lawinenphotodiode und der Ladeeinheit angeschlossen.

Der Eingang ist mit der dritten Elektrode verbunden. Damit nutzt die Signalabgriffschaltung die bereitgestellte Elektrode zum schnellen Auslesen. Allerdings sind nachteilige Effekte der Schaltkreise zum Vorspannen auf das Auslesen durch das erfindungsgemäße Kopplungselement ohnehin unterdrückt. Insofern ist ein schnelles Auslesen weitgehend unabhängig von der dritten Elektrode, die also alternativ nicht vorgesehen oder nicht genutzt sein kann. Die Signalabgriffschaltung ist dann mit der ersten Elektrode oder der zweiten Elektrode verbunden.

Elektronische Schaltungen weisen in der Regel eine zeitliche Latenz auf, die von unterschiedlichen Einflüssen mehr oder weniger abhängig ist. Wird eine Schaltung für eine Zeitmessung eingesetzt, sind diese Einflüsse störend für die Genauigkeit und Reproduzierbarkeit einer Messung bei wechselnden Einflussgrößen (z. B. Temperatur). Ermittelt man die Störgrößen, können diese Fehler bis zu einem gewissen Grad korrigiert werden. Alternativ kann man entstehende Fehler im laufenden Betrieb durch geeignete Referenzmessungen quantifizieren und das Messergebnis entsprechend korrigieren. Deshalb ist in Weiterbildung der Erfindung ein zusätzlicher Signalkanal vorgesehen, über den ein zusätzliches Signal in die Signalabgriffschaltung einspeisbar ist. Die Einspeisung erfolgt kapazitiv. Eine solche kapazitive Einkopplung nach dem Photodetektor war bisher immer mit einer Verringerung der Bandbreite durch die zusätzliche Kapazität verbunden. Mit der Erfindung jedoch, die wie oben beschrieben das Signal derart abgreift, dass die Störungen durch Kapazitäten stark verringert sind, hat die zusätzliche Kapazität keine oder sehr kleine Rückwirkungen auf die Signalqualität des eigentlichen Messsignals. Auf diese Art können über den zusätzlichen Signalkanal zum Beispiel ein Referenzsignal, ein Prüfsignal oder andere Testsignale oder auch weitere Datensignale, z. B. die eines zweiten SPAD-Detektors im Wesentlichen störungsfrei eingespeist werden.

In vorteilhafter Weiterbildung weist ein optoelektronischer Sensor mindestens einen erfindungsgemäßen Lichtempfänger auf. Die Entfernung kann durch Triangulation bestimmt werden, wie in einem Triangulationstaster oder einer Stereokamera. Vorzugsweise erfolgt die Entfernungsmessung nach einem Lichtlaufzeitverfahren. In einem Pulslaufzeitverfahren wird mit einem Lichtsender ein kurzer Lichtpuls ausgesandt und die Zeit bis zum Empfang einer Remission oder Reflexion des Lichtpulses gemessen.

Alternativ wird bei einem Phasenverfahren Sendelicht amplitudenmoduliert und eine Phasenverschiebung zwischen Sende- und Empfangslicht bestimmt, wobei die Phasenverschiebung ebenfalls ein Maß für die Lichtlaufzeit ist. Das Lichtlaufzeitverfahren kann in einem eindimensionalen Entfernungstaster, einem Laserscanner oder einem Bildsensor einer 3D-Kamera nach dem Lichtlaufzeitprinzip genutzt werden. Weitere nicht abschließende Anwendungen des Lichtempfängers in einem optoelektronischen Sensor sind Codelesen oder Datenübertragung oder Kombinationen dieser Anwendungen in einem Sensor.

Das erfindungsgemäße Verfahren kann auf ähnliche Weise weitergebildet werden und zeigt dabei ähnliche Vorteile. Derartige vorteilhafte Merkmale sind beispielhaft, aber nicht abschließend in den sich an die unabhängigen Ansprüche anschließenden Unteransprüchen beschrieben.

Die Erfindung wird nachstehend auch hinsichtlich weiterer Merkmale und Vorteile beispielhaft anhand von Ausführungsformen und unter Bezug auf die beigefügte Zeichnung näher erläutert. Die Abbildungen der Zeichnung zeigen in:

Fig. 1       ein grobes Blockschaltbild eines SPAD-Detektors mit einer Signalabgriffschaltung;

Fig. 2a      den zeitlichen Verlauf eines direkt ausgelesenen Messsignals des SPAD-Detektors;

Fig. 2b      ein binäres Messsignal nach Bewertung des SPAD-Signals mit einer Schwelle;

Fig. 3a      eine herkömmliche Signalabgriffschaltung in Form eines Messwiderstands;

Fig. 3b      eine herkömmliche Signalabgriffschaltung in Form eines Transimpedanzverstärkers;

Fig. 3c      eine herkömmliche Signalabgriffschaltung in Form eines Transformators;

Fig. 4a      eine beispielhafte Darstellung der Schaltelemente eines SPAD-Detektors;

Fig. 4b      ein vereinfachtes Ersatzschaltbild zu Figur 4a, in dem nur eine Lawinenphotodiode gezeigt ist und die übrigen durch ihren Effekt als parasitäre Kapazität ersetzt sind;

Fig. 5       eine Darstellung einer erfindungsgemäßen Ausführungsform einer Signalabgriffschaltung für einen SPAD-Detektor mit einem aktiven Kopplungselement;

Fig. 6       eine abstrakte Modeldarstellung des aktiven Kopplungselements;

Fig. 7a      eine Darstellung einer weiteren erfindungsgemäßen Ausführungsform des aktiven Kopplungselements als Transistor in Basisschaltung;

Fig. 7b      eine Darstellung der Ausführungsform aus Fig. 7a mit zusätzlicher Spannungsquelle an der Basis des Transistors;

Fig. 8       eine Darstellung einer alternativen Umsetzung des aktiven Kopplungselements gemäß Figur 7 mit einem Feldeffekt- anstelle eines Bipolartransistors;

Fig. 9       eine Darstellung einer weiteren erfindungsgemäßen Ausführungsform einer Signalabgriffschaltung mit geänderter Anordnung der kapazitiven Auskopplung;

Fig. 10      eine Darstellung einer weiteren erfindungsgemäßen Ausführungsform einer Signalabgriffschaltung, die an eine Elektrode zum Vorspannen des SPAD-Detektors statt an eine dedizierte Ausleseelektrode angeschlossen ist;

Fig. 11      eine Darstellung einer weiteren erfindungsgemäßen Ausführungsform mit einer zusätzlichen Verarbeitungsstufe für den von der Signalabgriffschaltung bereitgestellten Messstrom;

Fig. 12      ein Vergleich des Frequenzgangs einer herkömmlichen und erfindungsgemäßen Signalabgriffschaltung;

Fig. 13    eine beispielhafte Darstellung eines kurzen Lichtpulses, der mit einer erfindungsgemäßen Signalabgriffschaltung ausgelesen ist;

Fig. 14    eine Darstellung einer weiteren Ausführungsform der Erfindung mit Partitionierung der Photodioden;

Fig. 15    eine Darstellung einer weiteren erfindungsgemäßen Ausführungsform mit zusätzlicher Signaleinspeisung.

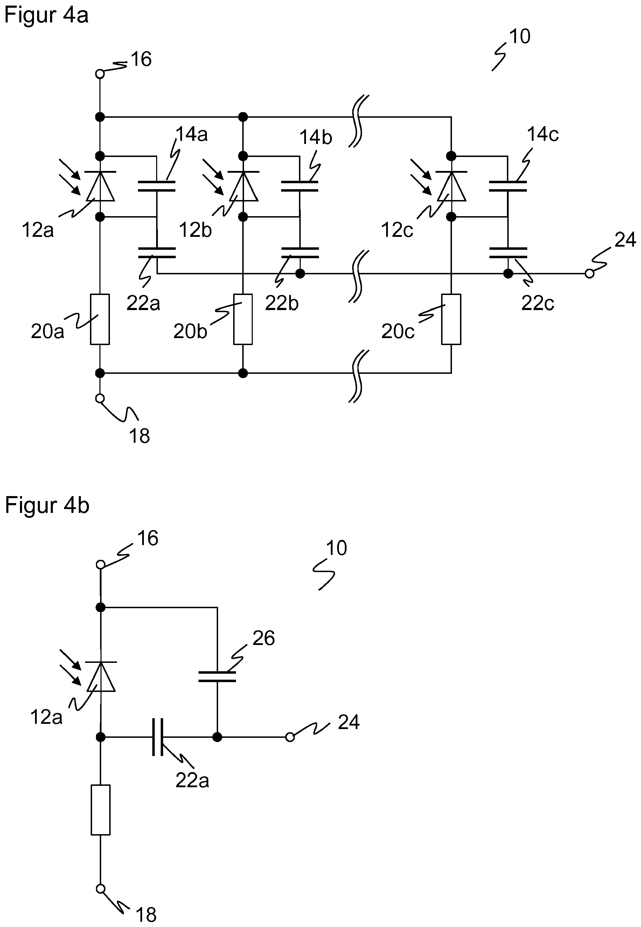

Figur 4a zeigt ein Beispiel für einen SPAD-Detektor 10 mit mehreren Lawinenphotodioden 12a-c, deren Kapazität durch parallel geschaltete Kondensatoren 14a-c dargestellt ist. Die Lawinenphotodioden 12a-c werden über eine erste Elektrode 16 und eine zweite Elektrode 18 vorgespannt (Bias), die dafür sorgen, dass die Kondensatoren 14a-c über Ladewiderstände 20a-c aufgeladen werden. Koppelkondensatoren 22a-c verbinden die Lawinenphotodioden 12a-c mit einer dritten Elektrode 24, über die ein Messsignal aus dem SPAD-Detektor 10 ausgelesen wird. Das Auslesen über die dritte Elektrode 24 kann Vorteile haben, ist aber nicht zwingend.

Die Darstellung des SPAD-Detektors 10 ist beispielhaft zu verstehen und zudem vereinfacht. Die Anzahl an Lawinenphotodioden 12a-c variiert je nach Bauteil und Zielanforderungen und kann bis zu mehreren tausend und darüber hinaus betragen. Üblicherweise bilden die Lawinenphotodioden 12a-c eine Matrixstruktur. Ein entsprechendes Bauelement kann beispielsweise in einem CMOS-Prozess hergestellt werden. Die Durchbruchspannung der Lawinenphotodiodenelemente ist deutlich geringer als bei herkömmlichen Lawinenphotodioden, beispielsweise von höchstens 50V oder 30V. Dabei sind die Lawinenphotodioden 12a-c gruppenweise oder insgesamt elektrisch zusammengeschaltet. Dies ermöglicht statistische Verfahren, die ausgleichen, dass eine einzelne Lawinenphotodiode 12a-c im Geiger-Modus einerseits schon durch ein einziges Fremdlichtphoton fehlausgelöst werden kann und andererseits nach jedem Auslösen einige Zeit lang nicht aktivierbar ist.

Figur 4b zeigt ein vereinfachtes Ersatzschaltbild zu Figur 4a aus Sicht einer einzelnen Lawinenphotodiode 12a. Deren eigene Kapazität ist hier der Übersicht halber nicht als parallel geschalteter Kondensator 14a dargestellt. Wie in der gesamten Beschreibung sind die gleichen Ziffern für die Bezugszeichen gleicher oder einander entsprechender Merkmale verwendet. Die übrigen Lawinenphotodioden 12b-c bilden aus Sicht der Lawinenphotodiode 12b-c parasitäre Kapazitäten 26, die durch sonstige parasitäre Effekte noch erhöht sein können. Die parasitäre Kapazität 26 summiert sich aus den meist zahlreichen weiteren Lawinenphotodioden 12b und kann deshalb deutlich größer sein als die Kapazität des zugehörigen Koppelkondensators 22a.

Wenn nun Licht einfällt, wird in den Lawinenphotodioden 12a-c ein Lawinendurchbruch ausgelöst. Besonders interessant ist der Fall, in dem nur sehr wenig Strahlungsleistung detektiert werden soll und dementsprechend nur eine oder wenige Lawinenphotodioden 12a-c ausgelöst werden. Dann sind die übrigen Lawinenphotodioden 12a-c eine relativ starke kapazitive Belastung, wodurch das eigentliche Ausgangssignal entsprechend gedämpft und in seiner Bandbreite beschnitten wird. Die parasitäre Kapazität 26 verhält sich wie ein Tiefpass, der hochfrequente Signale sperrt.

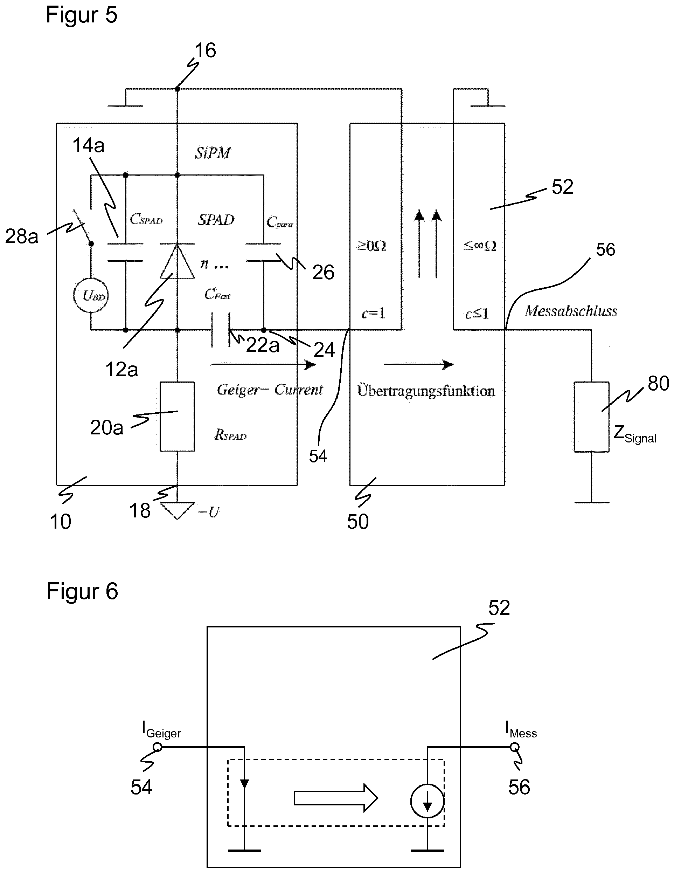

Figur 5 zeigt einen SPAD-Detektor 10 mit einer erfindungsgemäßen Signalabgriffschaltung 50, die das Messsignal im Gegensatz zu den herkömmlichen Lösungen auch für hohe Frequenzen im GHz-Bereich und trotz der parasitären Kapazität 26 bereitstellt.

Der Aufbau des SPAD-Detektors 10 entspricht weitgehend dem Ersatzschaltbild in Figur 4b, wird jedoch zum verbesserten Verständnis des Lichtempfangs mit Lawinenphotodioden im Geiger-Modus erneut erläutert. Der eigentliche Aufbau des Halbleiterbauteils wird als bekannt vorausgesetzt und nicht dargestellt. In dem Ersatzschaltbild zeigt die Lawinenphotodiode 12a zum einen das Verhalten einer Diode. Sie hat außerdem eine Kapazität, die durch den parallel geschalteten Kondensator 14a repräsentiert wird. Ein Lawinendurchbruch wird durch mindestens ein auftreffendes Photon ausgelöst, wobei dieser Vorgang wie ein Schalter 28a wirkt.

Im Bereitschaftszustand liegt über der Lawinenphotodiode 12a mit Hilfe der ersten Elektrode 16 und der zweiten Elektrode 18 eine Spannung oberhalb der Durchbruchspannung. Erzeugt dann ein einfallendes Photon ein Ladungsträgerpaar, so schließt dies gleichsam den Schalter 28a, so dass die Lawinenphotodiode 12a mit Ladungsträgern geflutet wird und ein sogenannter Geigerstrom fließt. Neue Ladungsträger entstehen aber nur, solange das elektrische Feld stark genug bleibt. Wird der Kondensator 14a so weit entladen, dass die Durchbruchspannung unterschritten ist, so kommt die Lawine von selbst zum Erliegen ("passive quenching"). Danach wird der Kondensator 14a aus den Elektroden 16, 18 über den Widerstand 20a wieder aufgeladen, bis wieder eine Spannung über der Durchbruchspannung an der Lawinenphotodiode 12a anliegt. Es gibt alternative Ausgestaltungen, in denen die Lawine von außen erkannt und daraufhin eine Entladung unter die Durchbruchspannung ausgelöst wird ("active quenching").

Während der Lawine steigt das Ausgangssignal rapide und unabhängig von der Intensität des auslösenden Lichts auf einen Maximalwert an und fällt dann nach dem Löschen der Lawine wieder ab. Die Zeitkonstante des Abfalls, welche eine Totzeit der Lawinenphotodiode 12a angibt, liegt typischerweise im Bereich einiger bis einiger zehn Nanosekunden. Die Totzeit ist keine absolute Totzeit, denn sobald die Vorspannung groß genug ist, um eine Lawine zu unterstützen, kann das Ausgangssignal auch wieder ansteigen, allerdings nicht im gleichen Maße wie aus dem Bereitschaftszustand. Der Verstärkungsfaktor beträgt bis zu $10^6$ und ergibt sich im Wesentlichen aus der maximalen Anzahl von Ladungsträgern, die von der Lawine in der Lawinenphotodiode 12a rekrutiert werden können.

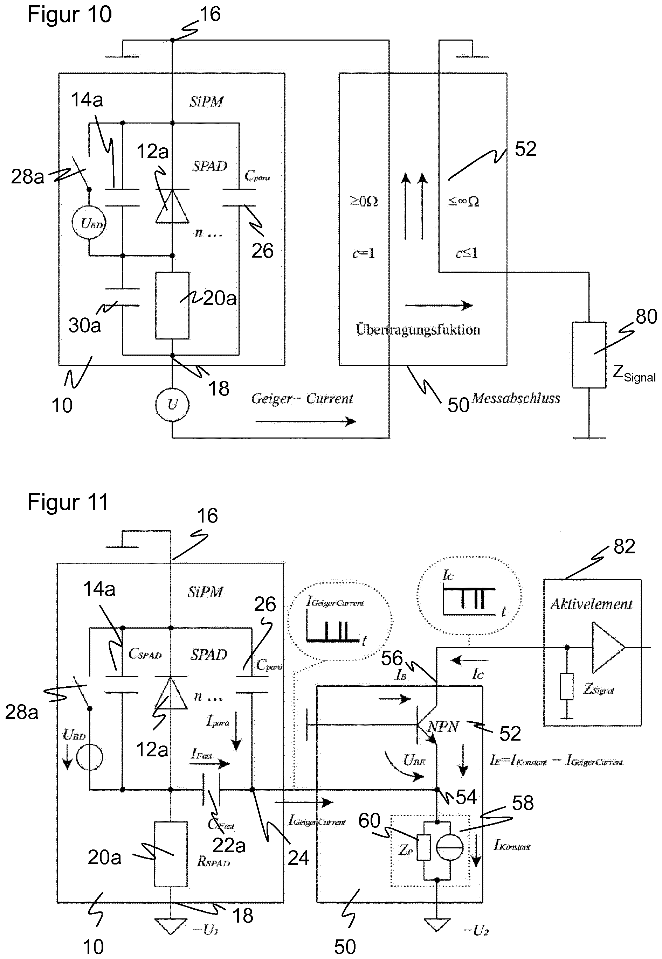

Die Funktion der Signalabgriffschaltung 50 ist nun, aus dem Geigerstrom während eines Lawinendurchbruchs ein Messsignal möglichst unter Ausnutzung des vollen Stromflusses abzuleiten, und zwar so, dass auch hochfrequente Anteile erhalten bleiben und ein hohes Signal/Rausch-Verhältnis erreicht wird. In Figur 5 ist die Signalabgriffschaltung 50 beispielhaft an die dritte Elektrode 24 und damit über den Koppelkondensator 22a an die Lawinenphotodiode 12a angeschlossen. Eine Variante, in der die dritte Elektrode 24 ungenutzt bleibt oder gar nicht vorgesehen ist, wird später anhand der Figur 10 erläutert.

Die Anforderungen an die Signalabgriffschaltung 50 sind auf den ersten Blick widersprüchlich. Für die Erzielung hoher Geschwindigkeiten beziehungsweise Bandbreiten wäre ein möglichst kleiner Signalwiderstand wünschenswert ($Z_{Signal} \rightarrow 0$). Gleichzeitig müsste der Signalwiderstand für eine möglichst hohe Empfindlichkeit eher groß gewählt werden ($Z_{Signal} >> 0$).

Der Kern der Signalabgriffschaltung 50 ist eine aktive Schaltungslösung in Form eines aktiven Kopplungselements 52, das diesen Widerspruch auflöst und sich durch drei Eigenschaften auszeichnet. Zum einen bietet es für den kapazitiv als Strompuls ausgekoppelten Geigerstrom praktisch keinen Widerstand. In der Figur 5 ist dies als Quasi-Kurzschluss auf die erste Elektrode 16 dargestellt. Die Schreibweise "≥0Ω" soll andeuten, dass ein solcher virtueller Kurzschluss gegen ein vorzugsweise festes Potential praktisch nicht ganz erreichbar ist, wobei weniger als ein Ohm durchaus möglich ist. Dies führt dazu, dass es über $C_{Para}$ keine relevanten Spannungsänderungen gibt. Dadurch wiederum werden Umladevorgänge in der parasitären Kapazität 26 verhindert, da dort die Spannung trotz der Lawine praktisch konstant bleibt und es dementsprechend dort keinen Stromfluss gibt. Insgesamt steht auf diese Weise dem aktiven Kopplungselement 52 eingangsseitig nahezu der gesamte durch den Koppelkondensator 22a fließende Geigerstrom während eines Lawinendurchbruchs zur Verfügung. Ohne den virtuellen Kurzschluss gegen ein vorzugsweise festes Potential, wie beispielsweise bei einem Sprung auf einen herkömmlichen Messwiderstand wie in Figur 3a, würden deutlich spürbare Anteile des Geigerstroms in der parasitären Kapazität 26 verloren gehen, und vor allem die schnellen, hochfrequenten Signalanteile durch das Tiefpassverhalten unterdrückt.

Zum zweiten erzeugt das Kopplungselement 52 ausgangsseitig einen Messstrom, der in seinem zeitlichen Verlauf und Pegel dem Geigerstrom entspricht. Dabei kann das Kopplungselement 52 den Messstrom durch seine Übertragungsfunktion auch gegenüber dem Geigerstrom gezielt verändern, ihn insbesondere verstärken. Es steht dafür an dem Kopplungselement 52 nahezu der vollständige Strom des Lawinendurchbruchs zur Verfügung. Diese Übertragung des Geigerstroms auf den Messstrom erfolgt anders als beispielsweise bei einer Transimpedanzverstärkung einstufig und vermeidet deshalb auch deren einleitend geschilderte Nachteile. Der Messstrom ist anschließend ausgangsseitig als Detektionsergebnis zur Weiterverarbeitung abgreifbar.

Dabei sind zum dritten Eingangskreis und Ausgangkreis voneinander entkoppelt. Die Weiterverarbeitung des Messstroms hat also, in den technischen Grenzen einer realen Entkopplung, keinerlei Auswirkungen auf den Geigerstrom. Deshalb sind praktisch beliebige Nachfolgestufen möglich, auch wie in Figur 5 gezeigt ein endlicher Messwiderstand 80 zur Umwandlung des Messstroms in eine Signalspannung. Die einleitend beschriebenen ungünstigen Rückwirkungen auf den Geigerstrom bleiben wegen der Entkopplung aus.

Figur 6 zeigt das aktive Kopplungselement 52 ein weiteres Mal in einer abstrakten Modeldarstellung. An einem Eingang 54 fließt der Geigerstrom wegen des virtuellen Kurzschlusses praktisch ungehindert aus dem SPAD-Detektor 10 ab. Das aktive Kopplungselement 52 hält dazu die Spannung am Eingang 54 konstant. Umladevorgänge oder Stromflüsse durch die parasitäre Kapazität 26 können nicht mehr stattfinden, der Geigerstrom wird direkt und vollständig in die Schaltung des aktiven Kopplungselements 52 geleitet. An einem Ausgang 56 wird der Messstrom bereitgestellt. Die Kopplung erfolgt ausschließlich von Eingang 54 zu Ausgang 56, die Gegenrichtung ist gesperrt und damit entkoppelt. Der Messstrom speist sich aus einer Stromquelle des aktiven Kopplungselements 52 und nicht aus dem SPAD-Detektor 10. Ausgangsseitige Signaländerungen wirken sich allenfalls vernachlässigbar auf den Eingang 54 aus. Dabei steht der Pfeil, der den Eingang 54 mit dem Ausgang 56 verbindet, für eine Übertragungsfunktion, die insbesondere eine Verstärkung beinhaltet.

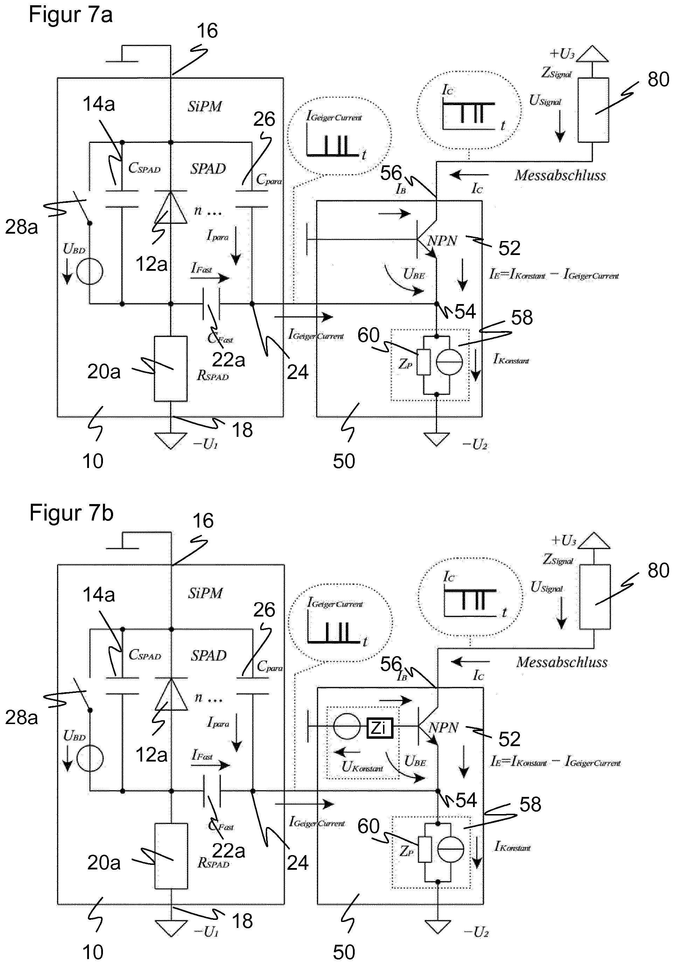

Figur 7a und b zeigen eine Ausführungsform der Signalabgriffschaltung 50, deren aktives Kopplungselement 52 von einem Transistor gebildet ist. Diese Signalabgriffschaltung 50 ist mit dem Eingang 54 des aktiven Kopplungselements 52 beispielhaft an den gleichen SPAD-Detektor 10 wie in Figur 5 über dessen dritte Elektrode 24 angeschlossen. Die Verwendung nur eines Transistors bedeutet, dass es sich um eine einstufige aktive Abgriffschaltung handelt.

Der Transistor ist in diesem Beispiel ein bipolarer NPN-Transistor in Basisschaltung. Den Eingang 54, dem von der dritten Elektrode 24 der Geigerstrom zugeführt wird, bildet der Emitter. Die Basis ist mit Masse oder allgemeiner einem festen Potential verbunden, das beispielsweise durch eine Spannungsquelle 55 bereitgestellt wird (Fig. 7b). Über Emitter-Basis ist der Eingang 54 wechselstrommäßig kurzgeschlossen gegen ein festes Potential, in Fig.7a ist dies das Massepotential. An der Basis könnte auch eine Spannungsquelle liegen wie in Fig. 7b gezeigt. Dann ist der Kurzschluss gegen das feste Potential $U_{konstant}$ geführt. Eine mögliche Impedanz Zi der Spannungsquelle macht sich am Eingang nur unwesentlich bemerkbar aufgrund des Verstärkungsfaktors des Transistors. In der Praxis wird Zi klein sein. Die Impedanz im virtuellen Kurzschluss sollte also möglichst klein sein, damit die Wirkung des Kurzschluss möglichst optimal ist.

Der Kollektor bildet den Ausgang 56, an dem der Messstrom bereitgestellt wird. Im Emitterkreis des Transistors befindet sich noch eine Konstantstromquelle 58 zwischen Eingang 54 und einer Versorgungsspannung-$U_2$. Dadurch fließt hier zu Zeiten außerhalb von Lawinendurchbrüchen ein Gleichstrom, der den Arbeitspunkt des Transistors einstellt. Die Konstantstromquelle 58 kann auch passiv durch einen Widerstand 60 realisiert sein. In den Figuren sind Konstantstromquelle 58 und Widerstand 60 parallel dargestellt und können alternativ oder gemeinsam realisiert sein. Am Ausgang 56 wird der Messstrom abgegriffen über eine Messimpedanz, die in Fig. 7a und b als einfache Impedanz 80 dargestellt ist. Alternativ kann die Messimpedanz 80 auch als Messschaltung mit aktiven und/oder passiven Elementen ausgebildet sein (Fig. 11).

Die Verhältnisse an dem Transistor werden nun zunächst im Ruhezustand (DC-Arbeitspunkt) und anschließend während eines Lawinendurchbruchs (AC-Arbeitspunkt) beschrieben.

Im Ruhezustand gelten für den Emitterstrom $I_E$, den Basisstrom $I_B$ und den Kollektorstrom $I_C$ die Zusammenhänge $I_E = I_B + I_C$ sowie $I_B = I_C / B$, wobei B der Verstärkungsfaktor ist. Setzt man die zweite Gleichung in die erste Gleichung ein, $I_E = I_C * (1/B + 1)$, und löst nach dem Kollektorstrom $I_C$ auf, so ergibt sich

$$I_C = I_E / (1/B + 1) = (I_{Konstant} - I_{GeigerCurrent}) / (1/B + 1).$$

Dabei wurden im letzten Schritt die entsprechenden Größen aus Figur 7a bzw. b für den Emitterstrom eingesetzt. Durch den Transistor fließt hier nur ein Ruhestrom, der durch die Stromquelle 58 mit $I_{Konst}$ vorgegeben ist. Ein schneller Signalstrom $I_{Geigercurrent}$ hat im Ruhezustand praktisch keinen Einfluss. Der im Emitterkreis eingeprägte Konstantstrom wird somit nahezu in gleicher Größe in den kollektorseitigen Ausgangskreis des Transistors übertragen.

Während eines Lawinendurchbruchs, wenn also eine Lawinenphotodiode 12a durch einfallendes Licht oder auch ein Störereignis ausgelöst wird, fließt ein positiver Strompuls $I_{Fast}$ über den Koppelkondensator 22a, die dritte Elektrode 24 und den Eingang 54 zum Emitterkreis des Transistors. Das ist praktisch der Geigerstrom, nämlich insoweit es gelingt, die parasitären Effekte und damit einen Strom $I_{Para}$ zu unterdrücken. Der eingeprägte Konstantstrom $I_{Konstant}$ bleibt idealerweise unbeeinflusst. Es gilt dann

$$I_E = I_{Konstant} - I_{GeigerCurrent} \qquad \text{bzw.} \qquad I_{Konstant} = I_E + I_{GeigerCurrent}$$

und somit wird der Geigerstrom nahezu unverändert auf den Emitterstrom $I_E$ übertragen.

Für die Weiterverarbeitung der schnellen Emitter-Stromänderung sollte nun der Transistor ein geeigneter Hochfrequenztransistor sein, dessen Hochfrequenzverstärkung oder differentielle Stromverstärkungsfaktor $\beta$ die Voraussetzung $B \geq \beta \gg 1$ erfüllt. Entsprechende Hochfrequenztransistoren mit Transitfrequenzen im Bereich von mehreren 10GHz sind verfügbar. Unter dieser Voraussetzung kann dann auch für die hochfrequenten Signalströme die oben für den Ruhezustand angegebene Gleichung herangezogen werden, indem B durch ß ersetzt wird:

$$I_C = I_{Konstant} - I_{GeigerCurrent} / (1/\beta + 1).$$

Das bedeutet dann, dass der Kollektorstrom und damit der Messstrom am Ausgang 56 auch für hochfrequente Eingangssignale quasi dem Emitterstrom entspricht. Die Basis-Emitter-Spannung $U_{BE}$ erfährt hierbei nur eine sehr geringe Änderung, da der Basisstrom über den Stromverstärkungsfaktor des Transistors ganz erheblich reduziert wird. Deshalb wird der Strom $I_{Para}$ durch die parasitäre Kapazität 26 im Idealfall vollständig unterbunden und es ist berechtigt, den Geigerstrom ($I_{GeigerCurrent}$) mit $I_{Fast}$ und damit dem Emitterstrom gleichzusetzen. Insgesamt ist so der Geigerstrom auf den Messstrom abgebildet.

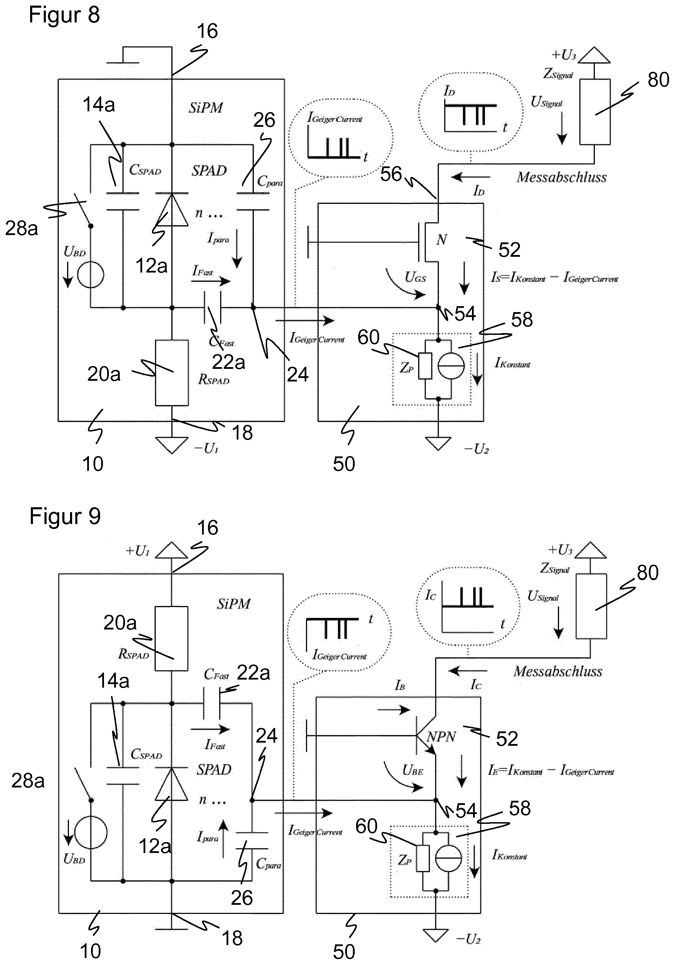

Figur 8 zeigt eine alternative Ausführungsform der Signalabgriffschaltung 50, die sich von derjenigen nach Figur 7 dadurch unterscheidet, dass der Transistor nun ein Feldeffekttransistor (FET) statt eines Bipolartransistors ist. Im dargestellten Fall handelt es sich um einen N-FET in Gateschaltung, bei dem also das Gate mit einem festen Potential, Source mit dem Eingang 54 und Drain mit dem Ausgang 56 verbunden ist.

Hier errechnet sich der Sourcestrom als Differenz des konstanten Stroms der Stromquelle 58 und des Geigerstroms. Wenn man den Gate-Strom vernachlässigt, ist der Drainstrom gleich dem Sourcestrom, so dass also die Drain-Wechselstromkomponente als Messstrom gerade dem invertierten Geigerstrom entspricht. Die Näherung gilt insoweit, wie die Spannung $U_{GS}$ am Eingang 54 tatsächlich konstant gehalten werden kann, was sich wiederum aus dem Kennlinienfeld des verwendeten FET ergibt.

Figur 8 illustriert, dass das aktive Kopplungselement 52 nicht auf einen bestimmten Transistortyp beschränkt ist. Das gilt auch für die Transistorpolarität, d. h. die Verwendung eines PNP-Transistors beziehungsweise eines P-FETs ist unter entsprechender Berücksichtigung der Polarität etwa bei der Versorgungsspannung genauso möglich.

Eine Basisschaltung wie in Figur 7a und b beziehungsweise Gateschaltung wie in Figur 8 hat zwar Vorteile, ist aber auch nicht zwingend. Beispielsweise kann ein Bipolartransistor auch in Emitterschaltung angeschlossen werden. Dazu wird der Emitter beispielsweise eines NPN-Transistors mit Masse verbunden. Vom Kollektor führt ein Arbeitswiderstand zu einer positiven Versorgungsspannungsquelle. Mit einem hochohmigen Widerstand zwischen Kollektor und Basis wird der Arbeitspunkt eingestellt. Der Geigerstrom wird über einen Koppelkondensator der Basis zugeführt. Ein Rückkoppel-netzwerk, bestehend aus der Reihenschaltung eines Widerstandes, eines Kondensators und einer Induktivität wird zusätzlich zwischen Kollektor und Basis geschaltet, und dabei legt der Widerstandswert die Wechselspannungsverstärkung im mittleren Frequenzbereich und den Eingangswiderstand fest, während die Induktivität für hohe Frequenzen die Rückkoppelwirkung reduziert und damit die Verstärkung der Stufe anhebt. Der Kondensator im Rückkoppel-Netzwerk dient nur der Gleichspannungsabtrennung. Diese Schaltungsvariante ist nicht so leistungsfähig wie die Basisschaltung, da der Eingangswiderstand höher ist. Weitere Nachteile sind die eingeschränkte Bandbreite und der im Vergleich zur Basisschaltung nicht so flache Frequenzgang der Verstärkung. Entsprechendes gilt für einen FET in Sourceschaltung.

Wie sich aus den dargestellten Ausführungsvarianten ergibt, bestehen diverse Möglichkeiten für die schaltungstechnische Umsetzung des aktiven Kopplungselements 52. Allgemein ist ein aktiver Schaltungsblock geeignet, der eine niedrige, kurzschlussähnliche Eingangsimpedanz aufweist beziehungsweise die Möglichkeit bietet, das Spannungspotential am Eingang 54 zumindest annähernd konstant zu halten. Die Ausgangsstufe kann dabei wie in den Beispielen Strom- jedoch alternativ auch Spannungscharakter haben. Die in der Signalabgriffschaltung 50 verwendeten Widerstände können ohmsche und/oder komplexe Eigenschaften haben. Sämtliche Bezugspotentiale sind beispielhaft zu verstehen, und auch bei den Bezugspunkten, wie Massebezug des SPAD-Detektors 10, Massebezug der Signalabgriffschaltung 50, Null-Potentiale von Ausgangs- und Versorgungsspannung, sind Variationen denkbar.

Nicht nur für das aktive Kopplungselement 52, sondern auch für die Beschaltung der Lawinenphotodiode 12a sowie den Anschluss der Signalabgriffschaltung 50 umfasst die Erfindung verschiedene Ausführungsformen, die nun beschrieben werden. Zunächst einmal wird der SPAD-Detektor 10 in den Figuren auch als Silizium-Photomultiplier (SiPM) bezeichnet. Das soll aber weder dessen Funktion in irgendeiner Weise einschränken noch den Halbleiter auf Silizium festlegen, denn es sind auch andere Halbleitermaterialien möglich.

Weiterhin kann der Ladewiderstand 20a wie in Figur 9 gezeigt kathodenseitig statt anodenseitig angeschlossen sein. Die Funktion ist dann ganz ähnlich, jedoch hat die Versorgungsspannung für die Vorspannung nun positive Polarität. Der Geigerstrom wird negativ und führt zu einer Zunahme des Stroms durch das aktive Kopplungselement 52. Die Polarität des Messstroms am Ausgang 56 wird dementsprechend negativ.

In den bisher gezeigten Beispielen ist die Signalabgriffschaltung 50 an die dritte Elektrode 24 angeschlossen. Der Abgriff kann aber prinzipiell über jede Elektrode, also die erste Elektrode 16, die zweite Elektrode 18 oder die dritte Elektrode 24 erfolgen, um beispielsweise Besonderheiten des SPAD-Detektors 10 oder der Signalabgriffschaltung 50 zu berücksichtigen. Bei einem anoden- oder kathodenseitigen Signalabgriff kann die dritte Elektrode 24 als Bezugsanschluss genutzt und beispielsweise mit Masse oder einem anderen Bezugspotential verbunden werden. Je nachdem, ob die erste Elektrode 16 oder die zweite Elektrode 18 als Anschluss für die Signalabgriffschaltung 50 dient, sollte der Ladewiderstand wie zwischen Figur 7a und b und Figur 9 seine Position von der zweiten Elektrode 18 zur ersten Elektrode 16 oder umgekehrt wechseln.

Nochmals alternativ muss die dritte Elektrode 24 gar nicht zwingend vorhanden sein. Figur 10 zeigt ein entsprechendes Beispiel eines SPAD-Detektors 10 mit nur zwei Anschlüssen und einer an der zweiten Elektrode 18 angeschlossenen Signalabgriffschaltung 50. Dabei ist der Ladewiderstand 20a mittels eines Kondensators 30a wechselstrommäßig überbrückt. Der Geigerstrom wird zwischen den beiden Elektroden 16, 18 des SPAD-Detektors 10 abgegriffen, während in diesem Beispiel zudem die Spannungsquelle für die Vorspannung in Reihe geschaltet ist. Die Auskopplung kann alternativ über ein zusätzliches Auskoppelnetzwerk erfolgen, das aus einem Widerstand und einem Koppelkondensator besteht.

Der SPAD-Detektor 10 ist mit der Außenbeschaltung wechselspannungsmäßig praktisch kurzgeschlossen. Damit ergibt sich auch bei Auslösen eines Lawinendurchbruchs keine nennenswerte Ausgangs-Wechselspannung. Ohne relevante Spannungsänderung an den Elektroden 16, 18 des SPAD-Detektors 10 bleibt auch die Spannung an der parasitären Kapazität 26 praktisch konstant. Es gibt folglich so gut wie keine Umladevorgänge, und der volle Geigerstrom steht am Eingang 54 zur Verfügung. Das aktive Kopplungselement 52 arbeitet wie oben beschrieben.

Durch die Entkopplung des Messstroms von dem Geigerstrom in dem aktiven Kopplungselement 52 spielt es für den auszulesenden Geigerstrom nahezu keine Rolle, wie der Messstrom weiterverarbeitet wird. Während in den bisherigen Ausführungsformen lediglich ein einfacher Messwiderstand 80 dargestellt ist, zeigt Figur 11 eine Alternative, in der ausgangsseitig eine weitere Verarbeitungsstufe 82 zur Signalaufbereitung folgt. Dies unterscheidet sich fundamental von einem herkömmlichen Transimpedanzverstärker gemäß Figur 3b, weil dort die Stufen miteinander koppeln. In Figur 11 gehört die Verstärkerstufe funktional nicht mehr zum Signalabgriff.

Die weitere Verarbeitungsstufe 82 in Figur 11 soll nur ein beliebiges Beispiel sein und kann in verschiedenster Art ausgestaltet sein. So kann die Verarbeitungsstufe 82 als Messschaltung mit aktiven und/oder passiven Elementen ausgebildet sein.

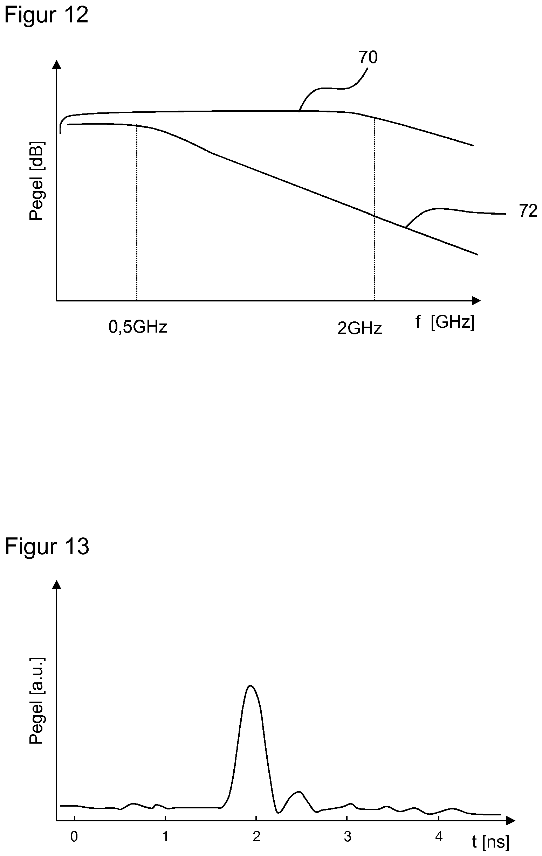

Die Figuren 12 und 13 sollen abschließend das durch die Erfindung deutlich verbesserte Hochfrequenzverhalten qualitativ illustrieren. Figur 12 zeigt das Ergebnis eines Testaufbaus, in dem ein Laser ein Signal auf den SPAD-Detektor 10 strahlt, das in seiner Amplitude mit einer variierenden Frequenz von 100 kHz bis 3GHz moduliert wird. Dabei zeigt der obere Verlauf 70 das Ergebnis mit einer erfindungsgemäßen Signalabgriffschaltung 50 und der untere Verlauf 72 den Vergleich zu einem herkömmlichen Signalabgriff. Der Frequenzgang 70 des erfindungsgemäßen Aufbaus zeigt einen sehr flachen Frequenzgang mit einer Bandbreite von 2GHz und einem deutlichen Signalabfall erst jenseits von 2-3 GHz. Das ist gegenüber dem Stand der Technik eine Vervielfachung, wo das Messsignal schon bei moderaten Frequenzen lange vor dem GHz-Bereich einbricht.

Nach dieser Betrachtung auf Frequenzebene zeigt Figur 13 noch ein weiteres Beispiel auf der Zeitebene. Hier wurde der SPAD-Detektor 10 mit einem kurzen Einzelpuls mit einer Pulsbreite von 250 ps angeregt. Figur 11 zeigt die Pulsantwort am Ausgang 56, in diesem Beispiel dem Kollektor eines Bipolartransistors. Die Pulsbreite beträgt 340 ps. Die Schaltung ist also in der Lage, sehr kurze Pulse deutlich unterhalb einer Nanosekunde zu detektieren.

Die vorgestellten Ausführungsformen der Signalabgriffschaltung 50 können in Halbleitertechnologie umgesetzt und auch auf Halbleiterebene zusammen mit dem eigentlichen SPAD-Detektor 10 auf einem gemeinsamen Bauteil integriert werden. Dabei können sowohl Single- als auch Multichip-Lösungen in Betracht gezogen werden, wobei der Prozess im Prinzip nicht festgelegt ist und beispielsweise ein Bipolar- oder MOS-Prozess sein kann.

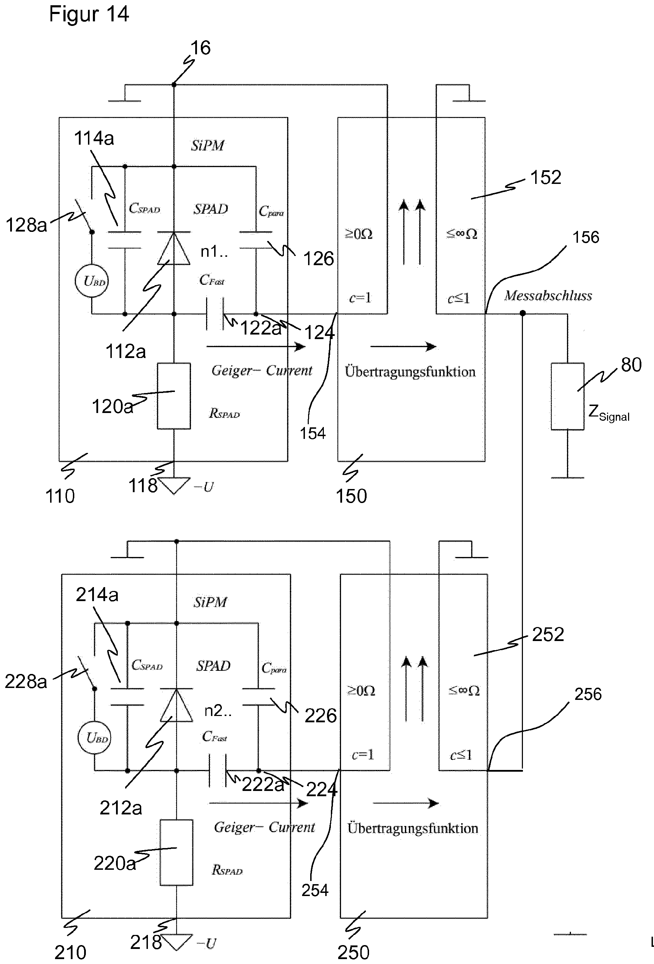

In weiterer Ausgestaltung der Erfindung können mehrere, also zwei oder mehr, erfindungsgemäße Lichtempfänger quasi zusammengeschaltet sein, wie dies in Fig. 14 dargestellt ist. Mit "quasi zusammengeschaltet" soll gemeint sein, dass ein erster SPAD-Detektor 110 mit n1 Lawinenphotodioden 112a-c und mit nachgeschalteter erster Signalabgriffschaltung 150 mit einem zweiten SPAD-Detektor 210 mit n2 Lawinenphotodioden 212a-c mit nachgeschalteter zweiter Signalabgriffschaltung 250 an ihren Ausgängen 156 und 256 gemeinsam an einen gemeinsamen Messabschluss geführt sind. Der Messabschluss kann wie oben die einfache passive Impedanz 80 sein oder eine aktive Verarbeitungsstufe (wie oben 82).

Eine solche "Partitionierung" aller n1+n2 SPAD (Lawinenphotodioden) in mehrere (hier in zwei) Gruppen hat verschiedene Vorteile. Durch Partitionierung in kleinere Einheiten mit weniger SPADs treten kleinere Kapazitäten auf, wodurch höhere Frequenzen erreicht werden können. Aufgrund der kleineren Kapazitäten fließen kleinere Ströme, so dass die Transistoren in den Signalabgriffschaltungen 150 und 250 kleiner dimensioniert sein können und somit nicht nur kostengünstiger sind, sondern auch besser (kompakter) auf einem Chip integriert werden können. Ein weiterer Vorteil ist die durch die Partitionierung erreichbare Laufzeitoptimierung auf dem Chip. Die Abstände der Komponenten auf dem Chip, die die Laufzeiten vorgeben, können optimiert gestaltet werden.

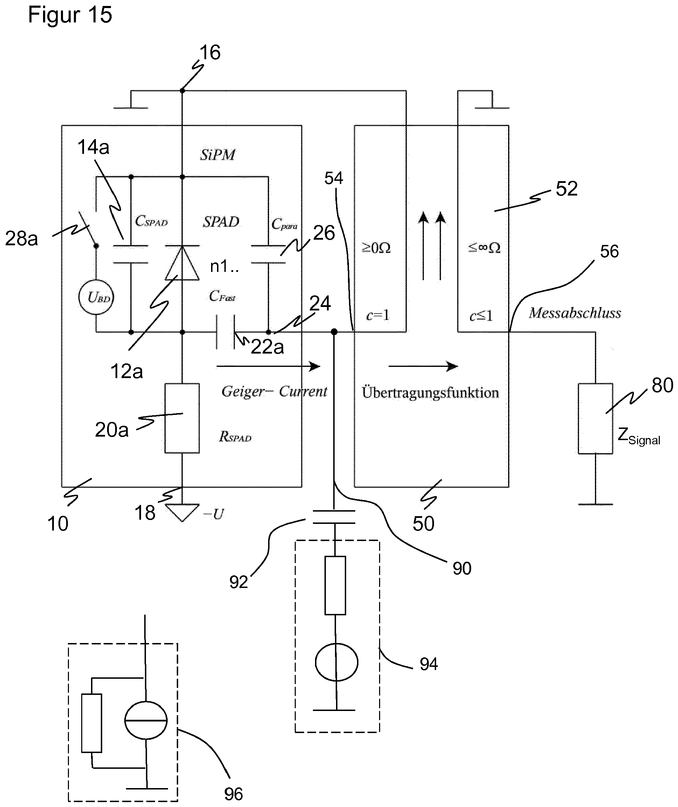

In einer weiteren Ausgestaltung der Erfindung ist, wie in Fig. 15 dargestellt, am Eingang 54 ein zusätzlicher Signalkanal 90 vorgesehen, über den ein zusätzliches Signal in die Signalabgriffschaltung 50 einspeisbar ist. Das Signal, das z. B. von einer Spannungsquelle 94 oder alternativ von einer Stromquelle 96 erzeugt werden kann, wird kapazitiv über eine Kapazität 92 in den Eingang 54 eingekoppelt. Eine solche kapazitive Einkopplung nach dem Photodetektor war bisher immer mit einer Verringerung der Bandbreite durch die zusätzliche Kapazität 92 verbunden. Mit der Erfindung jedoch, die wie oben beschrieben das Signal derart abgreift, dass die Störungen durch Kapazitäten stark verringert sind, hat die zusätzliche Kapazität 92 keine oder sehr kleine Rückwirkungen auf die Signalqualität des eigentlichen Messsignals. Auf diese Art kann über den zusätzlichen Signalkanal 90 zum Beispiel ein Referenzsignal, ein Prüfsignal oder andere Testsignale oder auch weitere Datensignal, z. B. die eines zweiten SPAD-Detektors 10 eingespeist werden.

**Patentansprüche**

1.   Lichtempfänger (10, 50) mit einer Vielzahl von Lawinenphotodiodenelementen (10, 12a-c), die jeweils mit einer Vorspannung oberhalb einer Durchbruchspannung vorgespannt und somit in einem Geiger-Modus betrieben sind, um bei Lichtempfang einen Geigerstrom auszulösen, wobei die Lawinenphotodiodenelemente (10, 12a-c) jeweils eine Lawinenphotodiode (12a-c) sowie eine erste Elektrode (16) und eine zweite Elektrode (18), über die sie vorgespannt sind, aufweisen, und jeweils zwischen Lawinenphotodiode (12a-c) und erster Elektrode (16) oder zweiter Elektrode (18) eine Ladeeinheit (20a-c) angeordnet ist, und mit einer Signalabgriffschaltung (50) zum Auslesen der Lawinenphotodiodenelemente (10, 12a-c), wobei die Signalabgriffschaltung (50) ein aktives Kopplungselement (52) mit einem Eingang (54), der mit den Lawinenphotodioden (10, 12a-c) verbunden ist, und einem Ausgang (56) aufweist, das einen Eingangsstrom am Eingang (54) auf einen in Verlauf und Pegel dem Eingangsstrom entsprechenden Messstrom abbildet,

**dadurch gekennzeichnet,**

**dass** die Lawinenphotodiodenelemente (10, 12a-c) eine dritte Elektrode (24) aufweisen, die zwischen der Lawinenphotodiode(12a-c) und der Ladeeinheit (20a-c) angeschlossen ist, und der Eingang (54) mit der dritten Elektrode (24) verbunden ist, so dass als Eingangsstrom der Geigerstrom auf den Messstrom abgebildet wird, indem der Eingang (54) für den Geigerstrom einen virtuellen Kurzschluss gegen ein Potential (Masse; -U<sub>BE</sub>; U<sub>const</sub>-U<sub>BE</sub>) bildet und der Ausgang (56) von dem Eingang (54) entkoppelt ist.

**2.** Lichtempfänger (10, 50) nach Anspruch 1,
wobei der Verlauf des Messstroms erst für Änderungen im höheren Gigahertzbereich, insbesondere oberhalb zwei oder drei GHz, durch frequenzbedingte Verluste von dem Geigerstrom abweicht.

**3.** Lichtempfänger (10, 50) nach Anspruch 1 oder 2,
wobei eine Messschaltung an den Ausgang (56) angeschlossen ist.

**4.** Lichtempfänger (10, 50) nach einem der vorhergehenden Ansprüche,
wobei die Signalabgriffschaltung (50) eine an das Kopplungselement (52) angeschlossene Konstantstromquelle (58) zur Einstellung von deren Arbeitspunkt aufweist.

**5.** Lichtempfänger (10, 50) nach einem der Ansprüche 1 bis 3,
wobei die Signalabgriffschaltung (50) einen an das Kopplungselement (52) angeschlossenen Widerstand (60) zur Einstellung von deren Arbeitspunkt aufweist.

**6.** Lichtempfänger (10, 50) nach einem der vorhergehenden Ansprüche,
wobei das Kopplungselement (52) dafür ausgebildet ist, die eingangsseitige Spannung konstant zu halten.

**7.** Lichtempfänger (10, 50) nach einem der vorhergehenden Ansprüche,
wobei das Kopplungselement (52) genau einen Transistor aufweist.

**8.** Lichtempfänger (10, 50) nach Anspruch 7,
wobei der Transistor in Basisschaltung oder Gateschaltung betrieben ist, indem der Eingang (54) mit dem Emitter oder mit Source, der Ausgang (56) mit dem Kollektor oder mit Drain und die Basis oder das Gate mit einem festen Potential verbunden ist.

**9.** Lichtempfänger (10, 50) nach einem der vorhergehenden Ansprüche,
wobei die dritte Elektrode (24) für ein kapazitives Auskoppeln des Geigerstroms ausgebildet ist.

**10.** Lichtempfänger (10, 50) nach einem der vorhergehenden Ansprüche,
wobei am Eingang ein zusätzlicher Signalkanal vorgesehen ist, über den ein zusätzliches Signal kapazitiv in die Signalabgriffschaltung (50) einspeisbar ist.

**11.** Optoelektronischer Sensor, mit mindestens einem Lichtempfänger (10, 50) nach einem der vorhergehenden Ansprüche, wobei der Sensor zur Entfernungsmessung nach einem Lichtlaufzeitverfahren und/oder als Codeleser und/oder zur Datenübertragung ausgebildet ist.

**12.** Verfahren zum Auslesen von Lawinenphotodiodenelementen (10, 12a-c), die jeweils eine Lawinenphotodiode (12a-c) aufweisen und über eine erste Elektrode (16) und eine zweite Elektrode (18) mit einer Vorspannung oberhalb einer Durchbruchspannung vorgespannt und somit in einem Geiger-Modus betrieben werden, wobei die Lawinenphotodiodenelemente (10, 12a-c) bei Lichtempfang einen Geigerstrom auslösen und anschließend über eine jeweils zwischen Lawinenphotodiode (12a-c) und erster Elektrode (16) oder zweiter Elektrode (18) angeordnete Ladeeinheit (20a-c) eine Aufladung erfolgt, wobei der Geigerstrom aufgrund eines virtuellen Kurzschlusses gegen ein Potential (Masse; -U<sub>BE</sub>; U-<sub>const</sub>-U<sub>BE</sub>) durch eine Verbindung zwischen Lawinenphotodiodenelement (10) und einem Eingang (54) eines aktiven Kopplungselements (52) fließt, in dem Kopplungselement (52) auf einen in Verlauf und Pegel dem Geigerstrom entsprechenden Messstrom an einem Ausgang (56) der Kopplungselements (52) abgebildet wird und der Ausgang (56) von dem Eingang (54) entkoppelt ist und somit eine Weiterverarbeitung des Messstroms den Geigerstrom nicht beeinflusst, wobei der Geigerstrom von dem Kopplungselement (52) über eine dritte Elektrode (24) der Lawinenphotodiodenelemente (10, 12a-c) abgegriffen wird, die zwischen der jeweiligen Lawinenphotodiode(12a-c) und der Ladeeinheit (20a-c) angeschlossen ist.

**Claims**

**1.** A light receiver (10, 50) having a plurality of avalanche photo diode elements (10, 12a-c) which are biased with a bias voltage greater than a breakthrough voltage and are thus operated in a Geiger mode in order to trigger a Geiger current upon light reception, wherein the avalanche photo diode elements (10, 12a-c) comprise an avalanche photo diode (12a-c) as well as a first electrode (16) and a second electrode (18) used for biasing and wherein a charging unit (20a-c) is arranged between a respective avalanche photo diode element (12a-c) and the first electrode (16) or the second electrode (18), and having a signal detection circuit (50) for reading out the avalanche photo diode elements (10, 12a-c), wherein the signal detection circuit (50) comprises an active coupling element (52) having an input (54) connected to the avalanche photo diodes (10, 12a-c) and an output (56), the active coupling element (52) mapping an input current at the input (54) to a measuring current corresponding to the input current in its course and level,

**characterized in that** the avalanche photo diode elements (10, 12a-c) comprise a third electrode (24) connected between the avalanche photo diode (12a-c) and the charging unit (20a-c), the input (54) being connected to the third electrode (24), thus the Geiger current as the input current being mapped to the measurement current **in that** the input (54) forms a virtual short-circuit for the Geiger current with respect to a potential (ground, $-U_{BE}$; $U_{const}-U_{BE}$), and the output (56) is decoupled from the input (54).

2. The light receiver (10, 50) according to claim 1,
   wherein the course of the measuring current deviates from the Geiger current only for fluctuations in a higher Gigahertz range, in particular above 2 GHz or 3 GHz.

3. The light receiver (10, 50) according to claim 1 or 2,
   wherein a measurement circuit is connected to the output (56).

4. The light receiver (10, 50) according to any of the preceding claims,
   wherein the signal detection circuit (50) comprises a constant current source (58) connected to the coupling element (52) for setting its operating point.

5. The light receiver (10, 50) according to any of claims 1 to 3,
   wherein the signal detection circuit (50) comprises a resistor (60) connected to the coupling element (52) for setting its operating point.

6. The light receiver (10, 50) according to any of the preceding claims,
   wherein the coupling element (52) is configured to maintain a constant voltage at the input side.

7. The light receiver (10, 50) according to any of the preceding claims,
   wherein the coupling element (52) comprises exactly one transistor.

8. The light receiver (10, 50) according to claim 7,
   wherein the transistor is operated in a common base circuit or gate circuit in that the input (54) is connected to emitter or source, the output (56) is connected to collector or drain, and base or gate is connected to a fixed potential.

9. The light receiver (10, 50) according to any of the preceding claims,
   wherein the third electrode (24) is configured for a capacitively coupled output of the Geiger current.

10. The light receiver (10, 50) according to any of the preceding claims,
    wherein an additional signal channel is provided at the input for capacitively feeding an additional signal into the signal detection circuit (50).

11. An optoelectronic sensor comprising at least one light receiver (10, 50) according to any of the preceding claims,
    wherein the sensor is configured for distance measurement and/or as a code reader and/or for data transmission.

12. A readout method for avalanche photo diode elements (10, 12a-c) each comprising an avalanche photo diode (12a-c), which are biased with a bias voltage greater than a breakthrough voltage via a first electrode (16) and a second electrode (18) and are thus operated in a Geiger mode, the avalanche photo diode elements (10, 12a-c) triggering a Geiger current upon light reception and subsequently being recharged via a charging unit (20a-c) connected between avalanche photo diode (12a-c) and first electrode (16) or second electrode (18), wherein the Geiger current flows through a connection between avalanche photo diode element (10) and an input (54) of an active coupling element (52) due to a virtual short-circuit with respect to a potential (ground, $-U_{BE}$; $U_{const}-U_{BE}$), and is mapped, in the coupling element (52), to a measuring current corresponding to the Geiger current in its course and level at an output (56) of the coupling element (52), and wherein the output (56) is decoupled from the input (54) so that the Geiger current is unaffected by further processing of the measuring current, wherein the Geiger current is read out by the coupling element (52) via a third electrode (24) of the avalanche photo diode elements ((10, 12a-c) which is connected between the respective avalanche photo diode (12a-c) and the charging unit (20a-c).

**Revendications**

1. Récepteur de lumière (10, 50) avec une pluralité d'éléments de photodiode à avalanche (10, 12a-c), qui sont respectivement soumis à une tension de polarisation au-dessus d'une tension de rupture et fonctionnent ainsi dans un mode de Geiger, afin de déclencher un courant de Geiger lors de la réception de lumière, dans lequel les éléments de photodiode à avalanche (10, 12a-c) comprennent respectivement une photodiode à avalanche (12a-c) ainsi qu'une première électrode (16) et une seconde électrode (18), via lesquelles ils sont soumis à une tension de polarisation, et une unité de charge (20a-c) est respectivement agencée entre la photodiode à avalanche (12a-c) et une première électrode (16) ou une seconde électrode (18), et comprenant un circuit de prélèvement de signal (50) destiné à lire les éléments de photodiode à avalanche (10, 12a-c), dans lequel le circuit de prélèvement de signal (50) comprend un élément de couplage actif (52) avec une entrée (54) qui est reliée aux photodiodes à avalanche (10, 12a-c), et avec une sortie (56) qui forme l'image d'un courant d'entrée à l'entrée (54) sur un courant de mesure dont l'évolution et le niveau correspond au courant d'entrée,
   **caractérisé en ce que**
   les éléments de photodiode à avalanche (10, 12a-c) comprennent une troisième électrode (24), qui est branchée entre la photodiode à avalanche (12a-c) et l'unité de charge (20a-c), et l'entrée (54) est reliée à la troisième électrode (24), de sorte que, à titre de courant d'entrée, l'image du courant de Geiger est formée sur le courant de mesure, du fait que l'entrée (54) pour le courant de Geiger forme un court-circuit virtuel vers un potentiel (masse ; $-U_{BE}$ ; $U_{const}-U_{BE}$) et la sortie (56) est découplée de l'entrée (54).

2. Récepteur de lumière (10, 50) selon la revendication 1,
   dans lequel l'évolution du courant de mesure s'écarte du courant de Geiger par des pertes dues à la fréquence, uniquement pour des variations dans la plage élevée des gigahertz, en particulier au-dessus de 2 ou 3 GHz.

3. Récepteur de lumière (10, 50) selon la revendication 1 ou 2,
   dans lequel un circuit de mesure est branché à la sortie (56).

4. Récepteur de lumière (10, 50) selon l'une des revendications précédentes,
   dans lequel le circuit de prélèvement de signal (50) comprend une source de courant constant (58) branchée à l'élément de couplage (52), pour le réglage de son point de travail.

5. Récepteur de lumière (10, 50) selon l'une des revendications 1 à 3, dans lequel le circuit de prélèvement de signal (50) comprend une résistance (60) branchée à l'élément de couplage (52), pour le réglage de son point de travail.

6. Récepteur de lumière (10, 50) selon l'une des revendications précédentes,
   dans lequel l'élément de couplage (52) est réalisé pour maintenir constante la tension du côté entrée.

7. Récepteur de lumière (10, 50) selon l'une des revendications précédentes,
   dans lequel l'élément de couplage (52) comprend exactement un transistor.

8. Récepteur de lumière (10, 50) selon la revendication 7,
   dans lequel le transistor est amené à fonctionner en circuit de base ou en circuit de grille, du fait que l'entrée (54) est reliée à l'émetteur ou à la source, la sortie (56) est reliée au collecteur ou au drain, et la base ou la grille est reliée à un potentiel fixe.

9. Récepteur de lumière (10, 50) selon l'une des revendications précédentes,
   dans lequel la troisième électrode (24) est réalisée pour un découplage capacitif du courant de Geiger.

10. Récepteur de lumière (10, 50) selon l'une des revendications précédentes,
    dans lequel un canal de signalisation additionnel est prévu à l'entrée, via lequel peut être injecté un signal additionnel par voie capacitive dans le circuit de prélèvement de signal (50).

**11.** Capteur optoélectronique, comprenant au moins un récepteur de lumière (10, 50) selon l'une des revendications précédentes, le capteur étant réalisé pour la mesure d'éloignement selon une procédure de temps de parcours de la lumière et/ou à titre de lecteur de code et/ou pour la transmission de données.

**12.** Procédé pour la lecture d'éléments de photodiode à avalanche (10, 12a-c), qui comprennent chacun une photodiode à avalanche (12a-c) et qui sont soumis à une tension de polarisation au-dessus d'une tension de rupture au moyen d'une première électrode (16) et d'une seconde électrode (18), et sont ainsi amenés à fonctionner dans un mode de Geiger, dans lequel les éléments de photodiode à avalanche (10, 12a-c) déclenchent un courant de Geiger lors de la réception de lumière, et il se produit ensuite un processus de charge au moyen d'une unité de charge (20a-c) agencée respectivement entre la photodiode à avalanche (12a-c) et la première électrode (16) ou la seconde électrode (18), dans lequel le courant de Geiger s'écoule, en raison d'un court-circuit virtuel vers un potentiel (masse ; $-U_{BE}$ ; $U_{const}-U$) à travers une liaison entre l'élément de photodiode à avalanche (10) et une entrée (54) d'un élément de couplage actif (52), dans l'élément de couplage (52) un courant de mesure qui correspond à l'évolution et au niveau du courant de Geiger est fourni à titre d'image à une sortie (56) de l'élément de couplage (52), et la sortie (56) est découplée de l'entrée (54) et ainsi une poursuite du traitement du courant de mesure n'influence pas le courant de Geiger, le courant de Geiger étant prélevé depuis l'élément de couplage (52) via une troisième électrode (24) des éléments de photodiode à avalanche (10, 12a-c), laquelle est branchée entre la photodiode à avalanche respective (12a-c) et l'unité de charge (20a-c).

Figur 1

110                    150

```
┌─────────┐        ┌─────────────┐
│         │        │             │
│  SPAD   │────────│  Abgriff-   │──────────────────→
│         │        │  schaltung  │    Messsignal
└─────────┘        └─────────────┘
```

Figur 2a

Figur 2b

Figur 3a

110          150

SPAD          $Z_{Signal}$

Figur 3b

110          $Z_{Signal}$          150

SPAD

Figur 3c

110          150

SPAD          $Z_{Signal}$

Figur 4a

Figur 4b

## Figur 5

## Figur 6

Figur 7a

Figur 7b

## Figur 8

## Figur 9

Figur 10

Figur 11

Figur 12

Figur 13

## Figur 14

## Figur 15

**IN DER BESCHREIBUNG AUFGEFÜHRTE DOKUMENTE**

**In der Beschreibung aufgeführte Patentdokumente**

- WO 2011117309 A2
- GB 2451678 A